# EUROPEAN PATENT APPLICATION

(11) **EP 2 712 283 A1**
(43) Date of publication of application: **26.03.2014**
(21) Application number: 12196701.2
(22) Date of filing: 12.12.2012
(51) Int. Cl.: H05K 1/03

(54) **Light-emitting apparatus and luminaire**

(30) Priority: 24.09.2012 JP 2012209839
(71) Applicant: Toshiba Lighting & Technology Corporation, Yokosuka-shi Kanagawa 237-8510 (JP)
(72) Inventor: Takahara, Yuichiro, Kanagawa, 237-8510 (JP); Kondo, Kazuya, Kanagawa, 237-8510 (JP)
(74) Representative: Willquist, Sofia Ellinor

(57) **Abstract**

A light-emitting apparatus according to exemplary embodiments includes a ceramic substrate (10), a plurality of first light-emitting elements (13) mounted on the ceramic substrate (10), and a plurality of receptacle portions (43) of monopole connectors (40). The light-emitting apparatus further includes a first line (21) configured to connect anodes of the first light-emitting elements (13) and a first receptacle portion from among the plurality of receptacle portions (43), and a second line (23) configured to connect cathodes of the first light-emitting elements (13) and a second receptacle portion from among the plurality of receptacle portions (43). The plurality of receptacle portions (43) each includes a metallic base portion (43b).

## Description

### FIELD

Embodiments described herein relates generally to a light-emitting apparatus and a luminaire.

### BACKGROUND

Examples of a light-emitting module (light-emitting apparatus) used in a light-emitting unit of a luminaire include, for example, a light-emitting module having a plurality of LEDs (Light-Emitting Diodes) mounted on a ceramic substrate. A plurality of connectors configured to connect the light-emitting module and a lighting unit configured to drive the LEDs are also mounted on the same substrate. Many of such connectors have a structure including a metallic member and a resin member combined to each other and allowing insertion and removal.

However, the difference in coefficient of thermal expansion between the ceramic substrate and the resin is large, and hence solder connecting the ceramic substrate and the connector including a resin is subject to distortion due to a cycle of increase and decrease of the temperature of the substrate in association with turning ON and OFF the LEDs. When turning ON and OFF the LEDs are repeated, cracks may be generated in the solder, and the connectors may come apart from the substrate in the worst scenario.

### BRIEF DESCRIPTION OF THE DRAWINGS

FIGs. 1A and 1B are schematic drawings illustrating a light-emitting apparatus according to a first embodiment;
FIG. 2 is a perspective view schematically illustrating a monopole connector;
FIG. 3 is perspective view schematically illustrating a receptacle of the monopole connector;
FIGs. 4A and 4B are plan views schematically illustrating wiring of the light-emitting apparatus;
Figs. 5A and 5B are schematic drawings illustrating a light-emitting unit of a luminaire according to a second embodiment; and
FIG. 6 is a block diagram illustrating a configuration of the luminaire.

### DETAILED DESCRIPTION

A light-emitting apparatus according to exemplary embodiments includes a ceramic substrate, a plurality of first light-emitting elements mounted on the ceramic substrate, and a plurality of receptacles of monopole connectors. The light-emitting apparatus further includes a first line configured to connect an anode of the first light-emitting element and a first receptacle from among the plurality of receptacles, and a second line configured to connect a cathode of the first light-emitting element and a second receptacle from among the plurality of receptacles. The plurality of receptacles each includes a metallic base portion.

A luminaire according to exemplary embodiments includes a light-emitting unit having the light-emitting apparatus, a lighting unit having a first lighting circuit configured to drive the first light-emitting elements, and a plurality of lead wires each having a plug for the monopole connector and configured to connect the first light emitting element and the first lighting circuit from the plug via each of the receptacles.

Referring now to the drawings, embodiments will be described below. The same parts in the drawings are designated by the same reference numerals, and detailed description thereof is omitted as needed, and the different portions will be described. In some cases, the respective portions will be described using an XYZ orthogonal coordinates shown in the drawings.

### [First Embodiment]

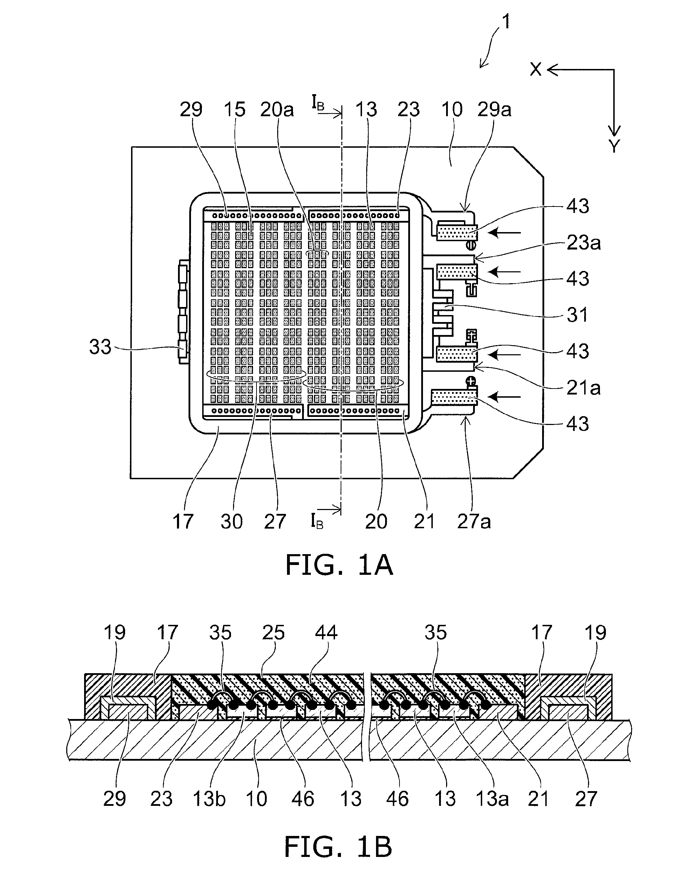

FIGs. 1A and 1B are schematic drawings illustrating a light-emitting apparatus 1 according to a first embodiment. FIG. 1A is a plan view illustrating a light-emitting surface 10a of the light-emitting apparatus 1. FIG. 1B is a cross-sectional view taken along the line I_{B}-I_{B} in FIG. 1A.

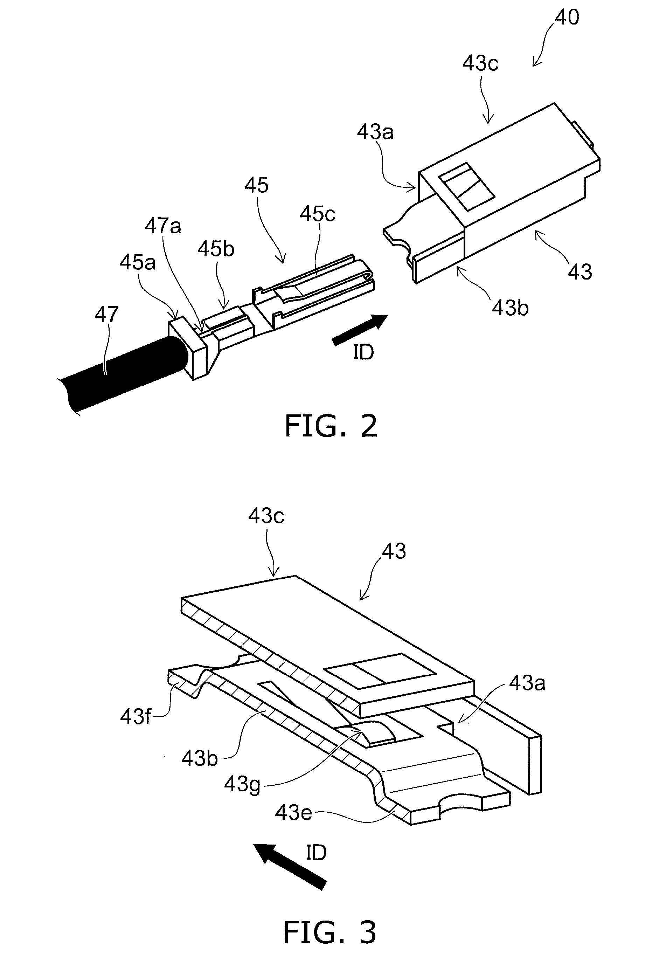

FIG. 2 is a perspective view schematically illustrating a monopole connector 40 according to the first embodiment.
FIG. 3 is a perspective view schematically illustrating a receptacle 43 of the monopole connector 40 according to the first embodiment.

The light-emitting apparatus 1 is a light-emitting module having a plurality of light-emitting elements, for example, light-emitting diodes (LEDs) mounted on a ceramic substrate 10. The ceramic substrate 10 is formed of aluminum oxide, for example, as a material, and may have a metallic layer on at least one of a front surface and a back surface thereof.

The light-emitting apparatus 1 includes a first light-emitting element group (hereinafter, referred to as an LED group 20) including a plurality of first light-emitting elements (hereinafter, referred to as LEDs 13) mounted on the ceramic substrate 10, and a second light-emitting element group (an LED group 30) including a plurality of second light-emitting elements (hereinafter, referred to as LEDs 15) mounted also on the ceramic substrate 10. The LED group 20 and the LED group 30 are provided in a line in an X direction, which is a first direction, on the ceramic substrate 10.

The LED group 20 is mounted between a first line (hereinafter, referred to as a line 21) and a second line (hereinafter, referred to as a line 23), and is electrically connected to the respective lines. The LED group 30 is mounted between a third line (hereinafter, referred to as a line 27) and a fourth line (hereinafter, referred to as a line 29), and is electrically connected to the respective lines.

In other words, the light-emitting apparatus 1 includes the plurality of lines 21, 23, 27 and 29 electrically connected to the LED group 20 and the LED group 30. The receptacles 43 of the monopole connectors 40 are mounted on end portions of the plurality of lines opposite from the LED groups. Hereinafter, end portions of the lines 21, 23, 27 and 29 on which the receptacles 43 are mounted are referred to as terminals 21a, 23a, 27a and 29a. In the following description, the end portions of the respective lines without the receptacles 43 mounted thereon may be conveniently referred to as the terminals 21a, 23a, 27a and 29a.

The monopole connector 40 includes the receptacle 43 and a plug 45 to be inserted into the receptacle 43. FIG. 2 illustrates the receptacle 43 and the plug 45 in a separated state.

The receptacle 43 includes a base portion 43b and a cover portion 43c. The base portion 43b is formed of a metal, and serves as an electrical conducting portion and a joint portion with respect to the ceramic substrate 10. In other words, the base portion 43b is bonded to each of the terminals 21a, 23a, 27a and 29a. The cover portion 43c is provided on the base portion 43b with a space which serves as an insertion port 43a.

The plug 45 includes an insertion portion 45c, a core-wire fixing portion 45b and a caulking portion 45a. The caulking portion 45a fixes the plug 45 to an end of a lead wire 47 via its coating. A core-wire 47a of the lead wire 47 is fixed to the core-wire fixing portion 45b by soldering, for example, and electrically connects the lead wire 47 and the plug 45.

The plug 45 is inserted into the ID direction indicated in FIG. 2, and is detachably fitted to the receptacle 43.

FIG. 3 is a perspective view illustrating a structure of the receptacle 43. The base portion 43b is formed into a bridge shape by a bending process and includes joint portions 43e and 43f at both ends in the inserting direction ID indicated in the same drawing. The joint portions 43e and 43f are secured to the end portions of the respective lines via solder. A contact 43g formed by a bending process is provided between the joint portion 43e and the joint portion 43f.

The contact 43g is displaceable in the vertical direction with respect to the inserting direction ID, and comes into contact with the insertion portion 45c of the plug 45 inserted into the insertion port 43a between the base portion 43b and the cover portion 43c. In this case, the contact 43g formed by the banding process functions as a leaf spring, is urged by its resilient force, and comes into contact with the insertion portion 45c. Accordingly, the base portion 43b of the receptacle 43 and the insertion portion 45c are reliably brought into contact with each other.

The base portion 43b is formed of a metal, and electrically connects each of the lines and the lead wires 47 via the joint portions 43e and 43f and the contact 43g.

The metal used for the base portion 43b is smaller in coefficient of thermal expansion than that of a resin, and the difference in coefficient of thermal expansion with respect to the ceramic substrate 10 is small. Therefore, distortion caused by a temperature cycle in association with turning ON and OFF the LED groups 20 and 30 is alleviated. Therefore, generation of cracks of solder that joins the joint portions 43e and 43f and the ceramic substrate 10 is inhibited.

Furthermore, the cover portion 43c configured to cover the base portion 43b may be formed of a metal. In other words, the entire part of the monopole connector 40 may be configured using a metal. Accordingly, distortion applied to the solder that joins each of the joint portions 43e and 43f and the ceramic substrate 10 may further be alleviated.

In this manner, in the receptacles 43 of the light-emitting apparatus 1, by forming at least the base portions 43b of a metal, the distortion generated between the ceramic substrate 10 and the receptacles 43 caused by the temperature cycle may be alleviated. Accordingly, the connectors may be held stably on the ceramic substrate 10. In other words, improvement of the reliability of the light-emitting apparatus 1 is achieved.

Furthermore, by using a metal for the entire part of the monopole connector 40, the size of the monopole connector 40 may be reduced. Although the connector may be of a type which cannot be disconnected after the plug has fitted to the receptacle instead of the connector which allows insertion and disconnection, the structure which allows insertion and disconnection is preferable when considering the convenience in assembly to the luminaire and the service thereof.

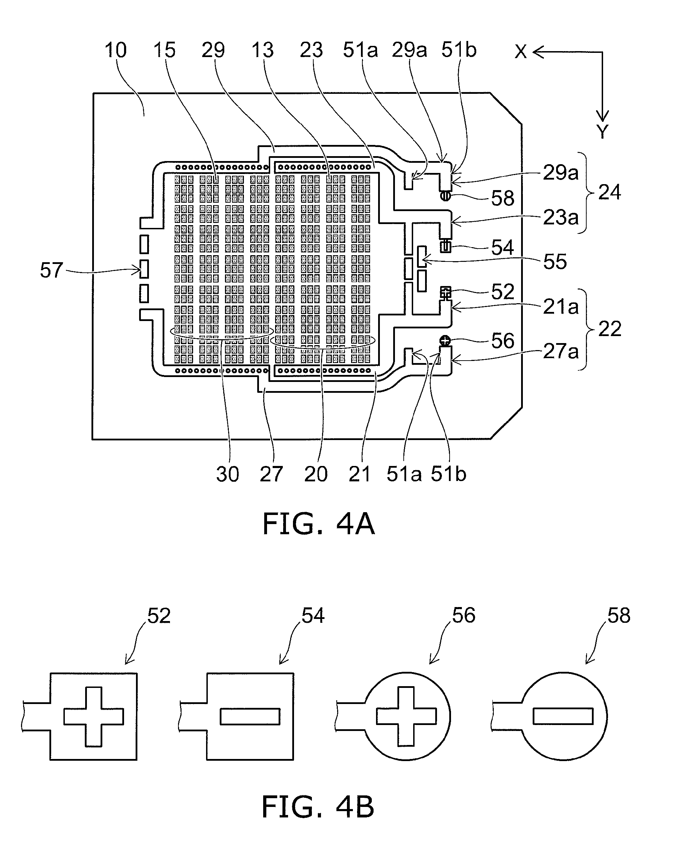

Subsequently, a configuration of the light-emitting apparatus 1 will be described in further detail referring to FIGs. 1A and 1B and FIG. 4.

As illustrated in FIG. 1A, a terminal group including the terminals 21a, 23a, 27a and 29a is provided in a line in the X direction on the side of the LED group 20 opposite from the LED group 30. In other words, the LED group 20, the LED group 30, and the terminal group are arranged in a line in the X direction, and the LED group 20 is mounted between the LED group 30 and the terminal group.

The light-emitting apparatus 1 also includes an outer peripheral frame 17 provided on the ceramic substrate 10 so as to surround the LED group 20 and the LED group 30. A resin layer 25 configured to cover the LED group 20 and the LED group 30 is provided inside the outer peripheral frame 17.

As illustrated in FIG. 1B, the resin layer 25 is a resin which seals the LED groups 20 and 30 and includes, for example, a phosphor 44. The phosphor 44 is excited by radiated light from the LED groups 20 and 30 and radiates light having a wavelength different from the excited light.

For example, silicone resin may be used for the resin layer 25. The outer peripheral frame 17 also includes a resin and, for example, includes silicone. The LEDs 13 included in the LED group 20 and the LEDs 15 included in the LED group 30 are, for example, blue LED and the phosphor 44 is, for example, YAG phosphor. The light-emitting apparatus 1 emits white light including blue light radiated from the LEDs 13 and 15 and yellow light radiated from the phosphor 44, which are mixed together.

The outer peripheral frame 17 covers parts of the line 21, the line 23, the line 27, and the line 29, respectively. Then, portions of the respective lines covered by the outer peripheral frame 17 are applied with a glass coat 19. Accordingly, a bonding force between the respective lines and the outer peripheral frame 17 may be enhanced.

As illustrated in FIG. 1B, the plurality of LEDs 13 mounted between the line 21 and the line 23 are connected in series via a metallic wire 35 . Anodes of the LEDs 13a positioned on one end of the series connection are electrically connected to the line 21 via the metallic wires 35. Cathodes of the LEDs 13b positioned on the other end of the series connection are also electrically connected to the line 23 via the metallic wires 35. A plurality of the LEDs 15 mounted between the line 27 and the line 29 are also connected in series via the metallic wire 35. Then, anodes of the LEDs 15 positioned one end of the series connection are connected to the line 27 via the metallic wire 35, and cathodes of the LEDs 15 positioned on the other end are connected to the line 29 via the metallic wire 35.

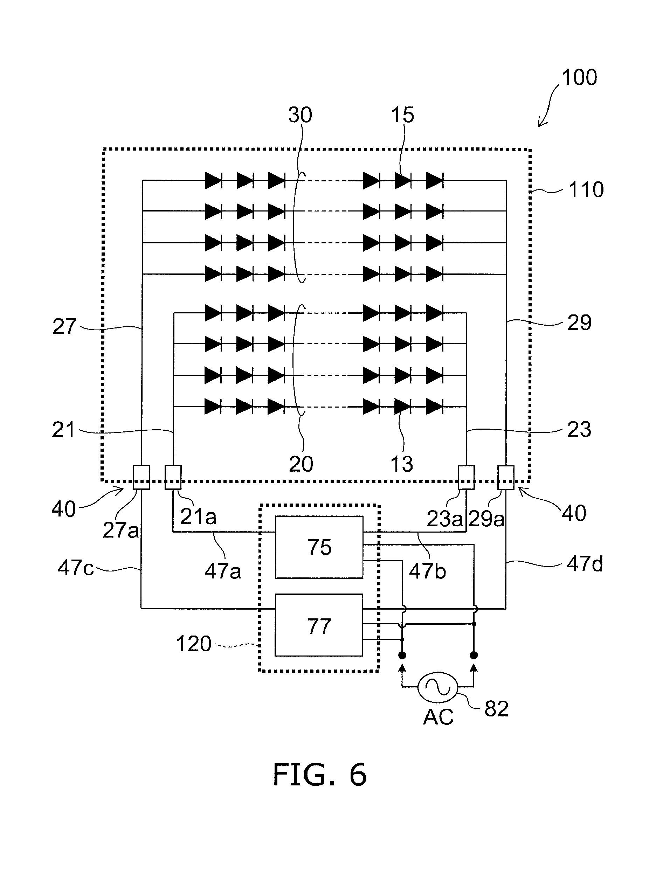

In this embodiment, the LED group 20 mounted between the line 21 and the line 23 includes four LED groups 20a connected in series, and the respective LED groups 20a include fifty-seven LEDs 13. Accordingly, the LED group 20 may be caused to emit light by applying a voltage of, for example, 160V between the line 21 and the line 23. The same applies to the LED group 30 mounted between the line 27 and the line 29 (see FIG. 6).

The LEDs 13 and the LEDs 15 are mounted on the ceramic substrate 10 via an adhesive agent 46, and the respective LEDs are connected by metallic wires with each other. Therefore, it is not necessary to form a land pattern for mounting chips and a bonding pad for wire bonding in an area where the LED group 20 is mounted and an area where the LED group 30 is mounted. Therefore, the respective LEDs may be mounted at a minimum distance apart from each other considering heat radiating properties or workability. Accordingly, reduction in size of the light-emitting apparatus 1 may be achieved. In addition, a light-emitting pattern having no uneven brightness is realized, and control of light-distribution characteristics is facilitated.

Chip capacitors 31 and 33 are mounted on both sides of the outer peripheral frame 17 in the X direction. The chip capacitor 31 removes a power source noise between the line 21 and the line 23, and the chip capacitor 33 removes a power source noise between the line 27 and the line 29.

FIG. 4A is a plan view schematically illustrating wiring of the light-emitting apparatus 1 according to the first embodiment. FIG. 4A shows a state in which the outer peripheral frame 17, the chip capacitors 31 and 33, and the receptacle 43 are removed from the layout illustrated in Fig. 1A.

The line 21 electrically connects between the LED group 20 and the terminal 21a. The anodes of the LEDs 13 are connected to the line 21, and the terminal 21a and the anodes of the LEDs 13 are electrically connected. The terminal 21a includes a first receptacle from among the plurality of receptacles 43.

The line 23 electrically connects between the LED group 20 and the terminal 23a. The cathodes of the LEDs 13 are connected to the line 23, and the terminal 23a and the cathodes of the LEDs 13 are electrically connected. The terminal 23a includes a second receptacle from among the plurality of receptacles 43.

The line 27 electrically connects between the LED group 30 and the terminal 27a. The anodes of the LEDs 15 are connected to the line 27 and the terminal 27a and the anodes of the LEDs 15 are electrically connected. The terminal 27a includes a third receptacle from among the plurality of receptacles 43.

The line 29 electrically connects between the LED group 30 and the terminal 29a. The cathodes of the LEDs 15 are connected to the line 29 and the terminal 29a and the cathodes of the LEDs 15 are electrically connected. The terminal 29a includes a fourth receptacle from among the plurality of receptacles 43.

Accordingly, the LED group 20 and the LED group 30 mounted inside of the outer peripheral frame 17 may be operated using lighting circuits connected thereto respectively. In other words, the number of the LEDs to be mounted in light-emitting areas may be increased and hence the amount of light may be increased without using a lighting circuit having a large current capacity for driving all the LEDs.

In the second direction (the Y-direction) orthogonal to the first direction, the line 21 and the line 27 are arranged at positions adjacent to one end of the area where the LED group 20 is mounted. The line 23 and the line 29 are arranged at positions adjacent to the other end of the area where the LED group 20 is mounted. Furthermore, the line 21 is provided between the line 27 and the LED group 20, and the line 23 is provided between the line 29 and the LED group 20.

Accordingly, the length of the metallic wire 35 connecting between the LED group 20 and the line 21 and the length of the metallic wire 35 connecting between the LED group 30 and the line 27 may be equalized. Also, the length of the metallic wire 35 connecting between the LED group 20 and the line 23 and the length of the metallic wire 35 connecting between the LED group 30 and the line 29 may be equalized. Accordingly, bonding of the metallic wire 35 may be facilitated, and hence working efficiency may be improved. In addition, loops of the metallic wire 35 may be lined up to an optimum state. Accordingly, a risk of wire disconnection caused by a heat cycle generated by turning ON and OFF the driving current may be reduced.

A terminal group 22 (a first terminal group) including the terminal 21a and the terminal 27a and a terminal group 24 (a second terminal group) including the terminal 23a and the terminal 29a are arranged on the ceramic substrate 10 on a group-by-group basis in the Y direction. In other words, the lines 21 and 27 connected to the anodes of the LEDs 13 and 15 and the lines 23 and 29 connected to the cathodes are arranged respectively in bulk on both sides of the mounting area of the LED group 20. Since potential differences between the line 21 and the line 27 and between the line 23 and the line 29 are small, metallic migration in the proximities thereof may be inhibited. Accordingly, the improvement of the reliability of the light-emitting apparatus 1 is achieved.

FIG. 4B is a plan view schematically illustrating marks provided for identifying the terminals 21a, 23a, 27a and 29a. A mark 52 corresponds to the terminal 21a, a mark 54 corresponds to the terminal 23a, a mark 56 corresponds to the terminal 27a, and a mark 58 corresponds to the terminal 29a.

The respective marks may be formed, for example, by processing the same metallic layer as the respective lines. In other words, the lines 21, 23, 27 and 29 may be formed simultaneously by using photolithography. It is also possible to impress the lines on the surface of the ceramic substrate 10.

Plus marks of the mark 52 and the mark 56 indicate that the terminals 21a and 27a are plus terminals connected to the anodes of the LEDs. In contrast, minus marks of the mark 54 and the mark 58 indicate that the terminals 23a and 29a are minus terminals connected to the cathodes of the LEDs.

Outlines (squares) of the mark 52 and the mark 54 indicate that the terminal 21a and 23a are terminals connected to the LED group 20. In contrast, outlines (circles) of the mark 56 and the mark 58 indicate that the terminal 27a and 29a are terminals connected to the LED group 30.

In this manner, the light-emitting apparatus 1 is provided on the ceramic substrate, and includes marks for discriminating the lines connected to the anodes of the LEDs from the lines connected to the cathodes of the LEDs. The light-emitting apparatus 1 also includes marks for discriminating the lines connected to the LED group 20 from the lines connected to the LED group 30. Then, by combining these marks, the terminals 21a, 23a, 27a and 29a may be discriminated. Accordingly, the combination of the plurality of monopole connectors 40 mounted on the ceramic substrate 10 may be recognized easily, so that the connection of the lead wires 47 may be implemented without any mistake.

In the layout illustrated in FIG. 1, the inserting direction ID of the respective receptacles 43 mounted on the terminals 21a, 23a, 27a and 29a is all parallel to the X-direction. Accordingly, coupling of the light-emitting apparatus 1 and the lead wire 47 is facilitated, and the workability is improved.

Furthermore, the width of the area where the respective terminals are provided in the Y-direction is smaller than one of the width of the area on which the LED group 20 is mounted in the Y-direction and the width of the area on which the LED group 30 is mounted in the Y-direction having a wider width. Accordingly, in a state in which the receptacles 43 and the plugs 45 are fitted, deflection margin of the lead wires 47 in the Y-direction is reduced. Consequently, the reduction in size of the luminaire in which the light-emitting apparatus 1 is mounted is achieved.

### [Second Embodiment]

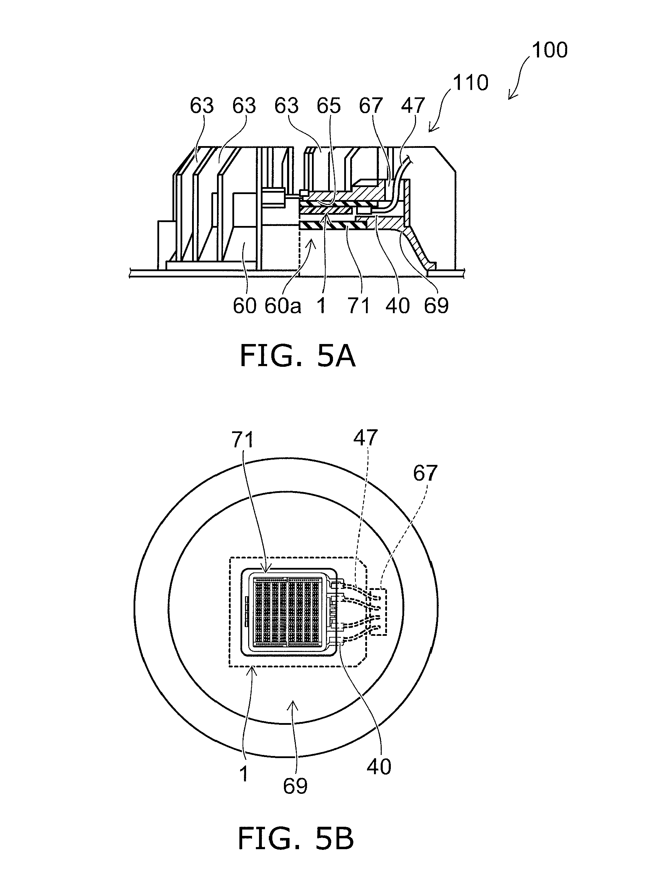

Figs. 5A and 5B are schematic drawings illustrating a light-emitting unit 110 of a luminaire 100 according to a second embodiment. FIG. 5A is a schematic drawing illustrating a side surface, partly cross section, of the light-emitting unit 110, and FIG. 5B is a bottom view. FIG. 6 is a block diagram illustrating a configuration of the luminaire 100 according to the second embodiment.

The luminaire 100 is a so-called down light, and is provided with the light-emitting unit 110 including the light-emitting apparatus 1 and a lighting unit 120. In this embodiment, the light-emitting unit 110 and the lighting unit 120 are installed separately from each other.

As illustrated in Fig. 5A, the light-emitting unit 110 includes a housing 60 and a plurality of heat-radiating plates 63. The housing 60 includes an opening 60a widening as it goes downward. The light-emitting apparatus 1 is mounted on a bottom surface 65 of the opening 60a, and the light-emitting surface 10a thereof faces downward. The housing 60 is an aluminum housing formed by die-casting, and diffuses heat of the light-emitting apparatus 1 efficiently from the bottom surface 65 of the opening 60a via the heat-radiating plates 63.

A reflection mirror 69 is provided on a side surface of the opening 60a. A light-shielding cover 71 connected to the reflection mirror 69 is arranged downward of the light-emitting apparatus 1. In other words, the light-emitting apparatus 1 is housed in a space between the bottom surface 65 of the opening 60a and the light-shielding cover 71.

The plurality of lead wires 47 are connected to the light-emitting apparatus 1 via the monopole connectors 40. Then, the plurality of lead wires 47 drawn out via an opening 67 provided in the housing 60 is connected to the lighting unit 120 (not illustrated).

By using the monopole connectors 40 which may be reduced in size in the light-emitting apparatus 1, reduction in size of the luminaire 100 is also achieved. For example, the distance between the bottom surface 65 and the light-shielding cover 71 may be subject to a restriction by the height of the monopole connector 40, so that the space for housing the light-emitting apparatus 1 may be reduced by reducing the height of the monopole connector 40.

As illustrated in FIG. 6, the luminaire 100 includes the light-emitting unit 110 including the LED group 20 and the LED group 30, and the lighting unit 120 configured to supply electric power to the LED group 20 and the LED group 30. The lighting unit 120 includes a first lighting circuit (hereinafter, referred to as a lighting circuit 75) to be connected to the light-emitting unit 110 via the plurality of lead wires 47, and a second lighting circuit (hereinafter, referred to as a lighting circuit 77).

The receptacle 43 of the monopole connector 40 is mounted on each of the plurality of terminals 21a, 23a, 27a and 29a. The plugs 45 fitted to the receptacles 43 are connected to respective ends of a plurality of lead wires 47a to 47d. Then, by fitting the receptacle 43 and the plug 45, the line 21 and the lead wire 47a, the line 23 and the lead wire 47b, the line 27 and the lead wire 47c, and the line 29 and the lead wire 47d are connected via the monopole connectors 40.

In other words, the lighting circuit 75 drives the LED group 20 via the terminal 21a connected to the anodes of the LEDs 13, and the terminal 23a connected to the cathodes of the LEDs 13. Also, the lighting circuit 77 drives the LED group 30 via the terminal 29a connected to the anodes of the LEDs 15, and the terminal 29a connected to the cathodes of the LEDs 15.

In contrast, the lighting circuits 75 and 77 are connected to, for example, a commercial power supply 82 via a consent plug. The lighting circuits 75 and 77 need only to have a capacity enough to supply a current to a half of the plurality of LEDs mounted on the substrate 10, and hence only half the capacity of the case where the power is supplied by one lighting circuit. In other words, lighting circuits with high reliability may be used at low cost. In this embodiment, an example in which the two LED groups are mounted on the substrate 10 is described. However, the configuration is not limited thereto. In other words, a configuration in which three or more LED groups are mounted and the lighting circuits are connected to the respective LED groups is also applicable.

As described thus far, according to the first and second embodiments, the number of the LEDs to be mounted in the light-emitting areas on the substrate 10 may be increased, and the amount of light may be increased. The LEDs to be mounted on the substrate 10 is divided into two groups, and the lines to be connected to the two groups respectively are provided. The two LED groups may be driven by the lighting circuits having a small current capacity. Therefore, the light source with a large amount of light may be driven with the lighting circuits having a small current capacity, so that high reliability and cost reduction are achieved.

Since the LED chips are connected in series with the metallic wires, the bonding pad does not have to be provided on the substrate. Therefore, the LED chips may be mounted in proximity to each other. Accordingly, the reduction in size of the light-emitting apparatus 1 is achieved by reducing the size of the light-emitting areas, and uneven light emission is prevented.

Furthermore, by mounting the receptacles 43 including the base portion 43b formed of a metal on the ceramic substrate, generation of solder cracks at the joint portions is inhibited, so that the reliability of the light-emitting apparatus 1 and the luminaire 100 is improved. Such advantages are obtained not only in the example described above in which the light-emitting elements are driven by the plurality of light-emitting circuits, but also in the light-emitting apparatus driven by one lighting circuit and the luminaire using the same.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A light-emitting apparatus comprising:
a ceramic substrate (10);
a plurality of first light-emitting elements (13) mounted on the ceramic substrate (10);
a plurality of receptacle portions (43) of monopole connectors (40) mounted on the ceramic substrate (10), the receptacle portions each including a metallic base portion (43b) ;
a first line (21) configured to connect anodes of the first light-emitting elements (13) and a first receptacle portion from among the plurality of receptacle portions (43); and
a second line (23) configured to connect cathodes of the first light-emitting elements (13) and a second receptacle portion from among the plurality of receptacle portions (43).

2. The apparatus according to claim 1, wherein each of the plurality of receptacle portions (43) is formed entirely of a metal.

3. The apparatus according to claim 1 or 2, wherein the first receptacle portion is mounted on an end portion (21a) of the first line (21),
the second receptacle portion is mounted on an end portion (23a) of the second line (23),
both ends of the base portions (43b) are soldered at each of the end portions (21a, 23a), and
each of the receptacle portions (43) have a contact point with respect to a plug portion (45) of the monopole connector (40) to be inserted therein at a center of the base portion (43b).

4. The apparatus according to any one of claims 1 to 3, wherein the inserting direction of the plug (45) to be fitted into the first receptacle portion is the same direction as the inserting direction of the plug portion (45) to be fitted to the second receptacle portion.

5. The apparatus according to any one of claims 1 to 4, wherein the plurality of first light-emitting elements (13) are connected in series, the anodes of first light-emitting elements (13a) positioned at one end of the series connection are connected to the first line (21), and the cathodes of first light-emitting elements (13b) positioned at the other end thereof are connected to the second line (23).

6. The apparatus according to any one of claims 1 to 5, wherein marks configured to discriminate the first line (21) provided on the ceramic substrate (10) and connected to the anodes, and the second line (23) connected to the cathodes are provided.

7. The apparatus according to any one of claims 1 to 6, further comprising:
a plurality of second light-emitting elements (15) mounted on the ceramic substrate (10);
a third line (27) connected to anodes of the second light-emitting elements (15); and
a fourth line (29) connected to cathodes of the second light-emitting element (15),
wherein the plurality of receptacle portions (43) further include a third receptacle portion to be connected to the third line (27) and a fourth receptacle portion to be connected to the fourth line (29), and
marks configured to discriminate a pair of the first line (21) and the second line (23) and a pair of the third line (27) and the fourth line (29) are provided.

8. The apparatus according to claim 7, wherein the plurality of second light-emitting elements (15) are connected in series, the anodes of the second light-emitting elements positioned at one end of the series connection is connected to the third line (27), and the cathodes of the second light-emitting elements positioned at the other end thereof are connected to the fourth line (29).

9. The apparatus according to claim 7 or 8, wherein the plurality of first light-emitting elements (13) and the plurality of second light-emitting elements (15) and the plurality of receptacle portions (43) are arranged in line on the ceramic substrate (10) in a first direction, and
the plurality of first light-emitting elements (13) are provided between the plurality of second light-emitting elements (15) and the plurality of receptacle portions (43).

10. The apparatus according to claim 9, wherein the inserting directions of the plug portions (45) to be fitted in the first receptacle portion, the second receptacle portion, the third receptacle portion, and the fourth receptacle portions are the first direction.

11. The apparatus according to claim 9 or 10, wherein the width of an area on which the plurality of receptacle portions (43) are mounted in a second direction orthogonal to the first direction is smaller than one of the width of an area on which the first light-emitting elements (13) are mounted in the second direction and the width of an area on which the second light-emitting elements (15) are mounted in the second direction having a wider width.

12. The apparatus according to any one of claims 9 to 11, wherein a first terminal group (22) including the first receptacle portion and the third receptacle portion and a second terminal group (24) including the second receptacle portion and the fourth receptacle portion are provided in a line in the second direction orthogonal to the first direction.

13. A luminaire comprising:
a light-emitting unit (110) having a light-emitting apparatus according to any one of Claims 1 to 12;
a lighting unit having a first lighting circuit (75) configured to drive the first light-emitting elements(13); and
a plurality of lead wires (47) having a plug (47) of a monopole connector (40) and configured to connect the first light-emitting elements (13) and the first lighting circuit (75) from the plug (47) via the first receptacle portion and the second receptacle portion.

14. The luminaire according to claim 13, wherein the light-emitting unit (110) further includes:
a plurality of second light-emitting elements (15) provided on the ceramic substrate (10);
a third line (27) connected to anodes of the second light-emitting elements (15); and
a fourth line (29) connected to cathodes of the second light-emitting elements (15), and
the plurality of receptacle portions (43) further include a third receptacle portion to be connected to the third line (27) and a fourth receptacle portion to be connected to the fourth line (29),
the lighting unit (120) further includes a second lighting circuit (77) configured to drive the plurality of second light-emitting elements (15),
the plurality of lead wires (47) further include a plurality of lead wires (47c, 47d) configured to connect the second light-emitting elements and the second lighting circuit via the third receptacle portion and the fourth receptacle portion.
